# EUROPEAN PATENT APPLICATION

(11) **EP 2 986 089 A1**
(43) Date of publication of application: **17.02.2016**
(21) Application number: 14783360.2
(22) Date of filing: 09.04.2014
(51) Int. Cl.: H05K 3/34, H01L 21/60

(54) **METHOD FOR MANUFACTURING SOLDER CIRCUIT BOARD, SOLDER CIRCUIT BOARD, AND METHOD FOR MOUNTING ELECTRONIC COMPONENT**

(30) Priority: 09.04.2013 JP 2013081208
(71) Applicant: Showa Denko K.K., Tokyo 105-8518 (JP)
(72) Inventor: SAKAI Takekazu, Tokyo 105-8518 (JP)
(74) Representative: Strehl Schübel-Hopf & Partner
(86) International application number: PCT/JP2014/060279
(87) International publication number: WO 2014/168175

(57) **Abstract**

A method for manufacturing a solder circuit board, the method including performing, in sequence, a resist formation step of partially coating a conductive circuit electrode surface on a printed wiring board with a resist, a tacky portion formation step of forming a tacky portion by imparting tackiness to a portion of the conductive circuit electrode surface not coated with the resist, a solder adhesion step of adhering a solder powder to the tacky portion, a resist removal step of removing the resist, and a first heating step of heating the printed wiring board and melting the solder powder.

## Description

### TECHNICAL FIELD

The present invention relates to a method for manufacturing a solder circuit board, a solder circuit board, and a method for mounting an electronic component. Priority is claimed on Japanese Patent Application No. 2013-081208, filed April 9, 2013, the content of which is incorporated herein by reference.

### BACKGROUND ART

In recent years, electronic circuits in which electronic components such as IC elements and semiconductor chips are soldered to a circuit pattern have become widely used. These circuit patterns are formed on plastic substrates, ceramic substrates or insulated substrates that have been coated with a plastic or the like.

When manufacturing these types of electronic circuits, examples of the method used for bonding the lead terminals of the electronic components to prescribed portions of the circuit pattern include the known methods described below. For example, a method is known in which a solder layer is formed in advance on the surface of the conductive circuit electrodes on the substrate, and a solder paste or flux is then printed onto prescribed portions on the solder layer. Subsequently, the electronic components are mounted onto the solder layer while the lead terminals are positioned appropriately relative to the solder paste, and soldering is then performed by conducting a reflow treatment. Further, another known method involves performing mounting using a flip chip bonder, in which a solder layer formed on a solder substrate and metal stud bumps formed on the bare chip side are superimposed, and the structure is then heated while pressure is applied, thereby melting the solder and mounting the chip.

Recently, as electronic products have become ever smaller, fine pitch electronic components such as FC (Flip Chips) having a pitch of 150 µm or less are being mounted on fine pitch substrates. As a result, solder circuit boards prepared by forming a fine pitch detailed circuit pattern on a substrate are now being demanded.

In the electronic component bonding methods described above, in order to form the circuit pattern composed of a solder film (hereafter referred to as the "solder circuit"), a plating method, hot air leveling (HAL) method, or a method in which a paste of a solder powder is printed onto the substrate and the paste is then subjected to a reflow treatment has typically been used. However, in a plating method, because it is difficult to increase the thickness of the solder layer, the bonding strength of the electronic component to the circuit pattern is weak, and there is a possibility that the electronic component may detach from the substrate. Further, in the HAL method and the method in which a paste is printed and then subjected to reflow, formation of a fine pitch circuit pattern has proven difficult.

Accordingly, in order to provide a method which ensures satisfactory thickness of the solder layer and enables formation of a solder circuit that is compatible with fine pitches, Patent Document 1 discloses a method in which a tacky portion that has been selectively imparted with tackiness is formed on an exposed portion of a metal circuit on a printing wiring board, a solder powder is adhered to the tacky portion, and the printed wiring board is then heated to melt the solder powder and form a circuit.

When manufacturing a solder circuit board having the above type of solder circuit formed thereon, the solder layer need not necessarily be formed over the entire surface of the metal circuit. In other words, the portions in which the solder layer are formed need only be those portions on the surface of the metal circuit to which an electronic component is to be bonded, and if the solder layer is also formed on the surface of the metal circuit outside of these portions, then the solder alloy used as the material for the solder layer is simply wasted.

Further, when melting occurs, the solder alloy migrates onto those portions of the metal circuit of broader width due to the effects of surface tension, meaning the thickness of the solder layer in those portions increases. If fluctuations develop in the solder layer thickness across the solder circuit board as a result of this phenomenon, then when the electronic component bonding step is performed after the solder layer formation step, adverse effects may appear, including fluctuations in the bonding strength between the lead terminals of the electronic components and the circuit pattern.

As a result, when the solder circuit formation method disclosed in Patent Document 1 is used to manufacture a solder circuit board, those portions of the surface of the metal circuit electrodes outside of the areas to which electronic components are to be bonded are often coated with a solder resist.

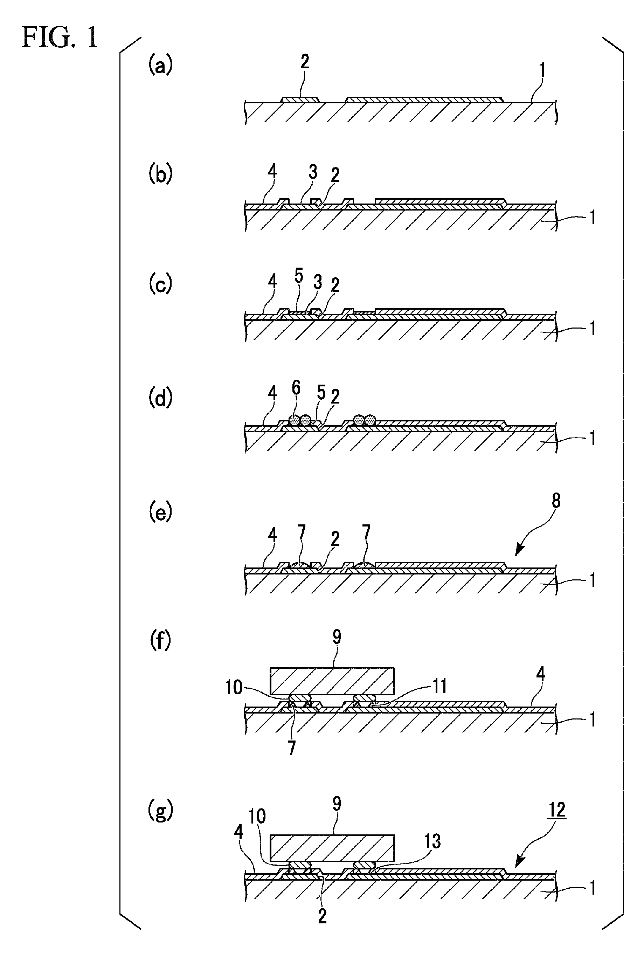

Specifically, as illustrated in FIG. 1(a), a circuit pattern 2 formed from a metal is first formed on the surface of a substrate 1. Next, as illustrated in FIG. 1(b), the portion of the surface of the circuit pattern 2 that is outside the bonding location 3 for the electronic component is coated with a solder resist 4. Subsequently, as illustrated in FIG. 1(c), tackiness is imparted to the surface of the circuit pattern 2 within the bonding location 3, thus forming a tacky portion 5. Then, as illustrated in FIG. 1(d), a solder powder 6 is adhered to the tacky portion 5. By subsequently melting this solder powder 6, a solder layer 7 such as that illustrated in FIG. 1(e) is formed, thus completing manufacture of a solder circuit board 8.

Subsequently, as illustrated in FIG. 1(f), the electrode portions 10 of an electronic component 9 are positioned on top of the solder layer 7, and a flip chip bonder is used to apply pressure and heat, thereby melting the solder circuit 11 formed from the solder layer 7. As a result, as illustrated in FIG. 1(g), a mounted substrate 12 is produced in which the electronic component 9 is bonded to the melted solder circuit 13 of the solder circuit board 8. The protruding portions provided on the electrode portions 10 are called stud bumps, and are provided for the purpose of stabilizing the bond with the solder layer 7.

### PRIOR ART LITERATURE

### Patent Documents

Patent Document 1: Japanese Unexamined Patent Application, First Publication No. Hei 07-7244

### DISCLOSURE OF INVENTION

### Problems to be Solved by the Invention

However, when the solder circuit formation method disclosed in Patent Document 1 is used to manufacture a solder circuit board, in order to miniaturize the solder circuit pattern, it is necessary to also miniaturize the pattern of the solder resist 4 shown in FIG. 1(b). However, there are limits to the degree of pattern miniaturization that is possible for typically used solder resists.

Further, a resin for securing the electronic component 9 illustrated in FIG. 1(g) is usually disposed between the electronic component 9 and the solder resist 4, but in shifting to a fine pitch, the electrode portions 10 of the electronic component 9 must be reduced in size, meaning ensuring adequate spacing becomes difficult.

In particular, if the shift to a fine pitch occurs when a bare chip is used as the electronic component, then because of the effects of the stud bumps formed on the bare chip, the electrode portions need to be formed in two or more rows. However, this means that the electrode portions of the electronic component become even smaller, meaning it becomes even more difficult to achieve the required spacing between the electronic component and the substrate.

In other words, in order to implement the steps illustrated in FIGS. 1(b) and 1(e), the resin that is used for the solder resist must be able to be used precisely with photolithography techniques, and must be able to withstand the melting temperature of the solder. The melting temperature of solder typically exceeds 200°C, but the number of types of resin capable of withstanding this type of temperature is limited, and within this limited number of resins, very few resins can be used for very fine patterning using photolithography techniques.

The present invention aims to address the issues outlined above, and has an object of providing a method for manufacturing a solder circuit board using a technique that enables a solder layer or solder bumps to be formed only in the very fine portions that are required, as well as providing a solder circuit board and a method for mounting an electronic component.

### Means for Solving the Problems

As a result of intensive efforts aimed at achieving the above object, the inventors of the present invention were able to complete the present invention. In other words, the present invention relates to the aspects described below.
(1) A method for manufacturing a solder circuit board, the method including performing, in sequence, a resist formation step of partially coating a conductive circuit electrode surface on a printed wiring board with a resist, a tacky portion formation step of forming a tacky portion by imparting tackiness to a portion of the conductive circuit electrode surface not coated with the resist, a solder adhesion step of adhering a solder powder to the tacky portion, a resist removal step of removing the resist, and a first heating step of heating the printed wiring board and melting the solder powder.
(2) A method for manufacturing a solder circuit board, the method including performing, in sequence, a resist formation step of partially coating a conductive circuit electrode surface on a printed wiring board with a resist, a tacky portion formation step of forming a tacky portion by imparting tackiness to a portion of the conductive circuit electrode surface not coated with the resist, a resist removal step of removing the resist, a solder adhesion step of adhering a solder powder to the tacky portion, and a first heating step of heating the printed wiring board and melting the solder powder.
(3) The method for manufacturing a solder circuit board disclosed above in (1) or (2), wherein a second heating step is provided immediately after the solder adhesion step.
(4) The method for manufacturing a solder circuit board disclosed above in any one of (1) to (3), wherein a step of applying a flux to the solder powder is provided between the resist removal step and the first heating step.
(5) The method for manufacturing a solder circuit board disclosed above in any one of (1) to (4), wherein the resist is an alkali development type resist, and in the resist removal step, an alkaline solution is used to remove the resist.
(6) The method for manufacturing a solder circuit board disclosed above in any one of (2) to (5), wherein the solder powder is an Sn-Pb-based solder powder, the heating temperature in the first heating step is within a range from 200°C to 350°C, and the heating temperature in the second heating step is within a range from 100°C to 180°C.
(7) The method for manufacturing a solder circuit board disclosed above in any one of (2) to (5), wherein the solder powder is an Sn-Ag-based solder powder, the heating temperature in the first heating step is within a range from 250°C to 350°C, and the heating temperature in the second heating step is within a range from 100°C to 180°C.
(8) The method for manufacturing a solder circuit board disclosed above in any one of (1) to (7), wherein the conductive circuit electrode is formed from a copper alloy, and in the tacky portion formation step, a reaction between the copper alloy and a benzotriazole-based derivative, naphthotriazole-based derivative, imidazole-based derivative, benzimidazole-based derivative, mercaptobenzothiazole-based derivative or benzothiazole thio-fatty acid-based derivative is used to impart tackiness to the portion not coated with the resist.
(9) A solder circuit board fabricated using the method for manufacturing a solder circuit board disclosed above in any one of (1) to (8).
(10) A method for mounting an electronic component, the method including an electronic component mounting step of mounting an electronic component on the solder circuit board disclosed above in (9), and an electronic component bonding step of subjecting the solder powder to reflow to bond an electrode portion of the electronic component to the solder circuit board.

### Effects of the Invention

According to aspects of embodiments of the present invention, the resist is removed after adhering the solder powder to the tacky portion, or the solder powder is adhered to the tacky portion after removing the resist, and in either case, the solder powder is then melted. As a result, the resist does not exist on the substrate when the solder is melted, meaning there is no necessity to use a heat-resistant resist. Accordingly, the range of resists that can be selected can be broadened, and for example, a resist that is ideal for fine pitch can be selected. This enables the formation of a fine pitch solder circuit. Further, because no solder resist exists on the mounting portion for the electronic component, the stud bumps of the electronic component can be made lower.

### BRIEF DESCRIPTION OF THE DRAWINGS

FIG. 1 is a diagram illustrating a conventional method for manufacturing a solder circuit board, wherein (a) to (g) are cross-sectional views.
FIG. 2 is a diagram illustrating a method for manufacturing a solder circuit board according to a first embodiment of the present invention, wherein (a) to (h) are cross-sectional views.
FIG. 3 is a diagram illustrating a conventional method for manufacturing a solder circuit board, wherein (a) to (c) are cross-sectional views.
FIG. 4 is a diagram illustrating a method for manufacturing a solder circuit board according to an embodiment of the present invention, wherein (a) to (c) are cross-sectional views.

### BEST MODE FOR CARRYING OUT THE INVENTION

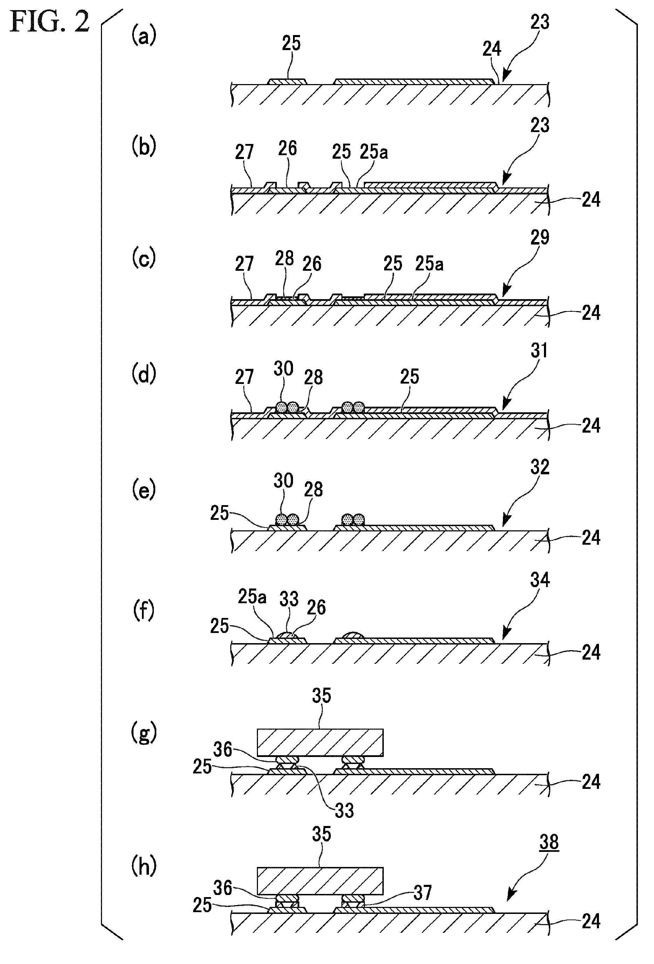

A method for manufacturing a solder circuit board that represents one embodiment of the present invention is described below with reference to FIG. 2. The drawings used in the following description are merely schematic representations, and the ratios and the like between lengths, widths and thicknesses need not necessarily be the same as the actual values.

The method for manufacturing a solder circuit board according to this embodiment (hereafter also simply referred to as "the manufacturing method") includes at least a resist formation step of partially coating a conductive circuit electrode surface on a printed wiring board with a resist, a tacky portion formation step of forming a tacky portion by imparting tackiness to a portion of the conductive circuit electrode surface not coated with the resist, a solder adhesion step of adhering a solder powder to the tacky portion, a resist removal step of removing the resist, and a first heating step of heating the printed wiring board and melting the solder powder. Further, in the manufacturing method of this embodiment, a second heating step for enhancing the adhesive strength of the solder powder to the tacky portion is provided immediately after the solder adhesion step. Moreover, the manufacturing method of this embodiment also includes, after the first heating step, an electronic component bonding step of bonding an electrode portion of the electronic component to the solder circuit of the solder circuit board.

A printed wiring board 23 such as that illustrated in FIG. 2(a) is prepared in advance. The printed wiring board 23 may be a single-sided printed wiring board, double-sided printed wiring board, multilayer printed wiring board or flexible printed wiring board or the like, prepared by forming, on a substrate 24, a circuit pattern (conductive circuit electrode) 25 using a conductive material such as a metal. Specific examples include wiring boards in which a metal plate is laminated to a plastic substrate, a plastic film substrate, a glass cloth substrate, a paper-base epoxy resin substrate, or a ceramic substrate or the like, or insulated wiring boards in which a plastic or a ceramic is coated onto a metal substrate. Further, examples of the conductive material include copper and copper alloys, but the conductive material is not limited to such materials, and any material which can be imparted with tackiness by the tackifier compound described below may be used. Besides copper, examples of such conductive materials include materials containing Ni, Sn, Ni-Al or solder alloys or the like.

### [Resist Formation Step]

First, as illustrated in FIG. 2(b), a portion of the surface 25a of the circuit pattern 25 on the printed wiring board 24 outside of a bonding location 26 for the electronic component is coated with a resist 27. As described below, because the resist 27 is removed before the solder powder is melted, there is no necessity to use a solder resist having heat resistance to the solder melting temperature for the resist 27. The resist 27 used in the manufacturing method of the present embodiment is a resist that can satisfactorily protect the portion of the surface 25a of the circuit pattern 25 to which tackiness is not imparted in the tacky portion formation step described below, and is also a resist that does not degrade the tackifier compound. In other words, a resist that can be applied to very fine patterning using photolithography techniques can be used for the resist 27, even if the resist does not exhibit heat resistance at the melting temperature of the solder powder. As a result, a bonding location 26 with a fine pitch minute pattern can be formed on the substrate 24.

Further, in the manufacturing method of the present embodiment, it is preferable to use a resist 27 that does not degrade the tackifier compound that is reacted at the surface 25a of the circuit pattern 25. The tackifier compounds described below have alkali resistance, and therefore the use of an alkali development type material as the resist 27, namely a resist formed from an alkali-soluble resin, is preferable. Examples of this type of resist include PVA-based photoresists, polyoxyalkylene-based photoresists and polyetherester-based photoresists. Further, examples of the developing solution for the resist 27 include tetramethylammonium hydroxide (TMAH), tetrabutylammonium hydroxide (TBAH) and ammonium salts.

### [Tacky Portion Formation Step]

Next, as illustrated in FIG. 2(c), a tacky portion 28 is formed by imparting tackiness to the surface 25a of the circuit pattern 25 in the bonding location 26 for the electronic component (the portion not coated with the resist 27). Specifically, as described below, the tacky portion 28 can be formed by reacting the tackifier compound at the surface 25a of the circuit pattern 25 in the bonding location 26.

In the manufacturing method of the present embodiment, it is preferable to use a tackifier compound that exhibits strong reactivity with the conductive material that constitutes the circuit pattern 25. When copper is used as the conductive material, examples of preferred tackifier compounds include benzotriazole-based derivatives, naphthotriazole-based derivatives, imidazole-based derivatives, benzimidazole-based derivatives, mercaptobenzothiazole-based derivatives and benzothiazole thio-fatty acid-based derivatives. These tackifier compounds exhibit particularly strong reactivity with copper, but can also impart tackiness to other conductive materials.

Benzotriazole-based derivatives that can be used favorably in the manufacturing method of the present embodiment are represented by general formula (1).

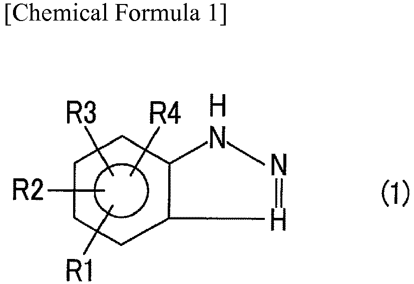

Each of R1 to R4 in general formula (1) independently represents a hydrogen atom, an alkyl group or alkoxy group having a carbon number of 1 to 16, F, Br, Cl, I, a cyano group, an amino group, or an OH group.

The benzotriazole-based derivatives represented by general formula (1) generally exhibit greater tackiness as the carbon number of R1 to R4 increases. Accordingly, the carbon number of each of R1 to R4 is preferably from 5 to 16.

Naphthotriazole-based derivatives that can be used favorably in the manufacturing method of the present embodiment are represented by general formula (2).

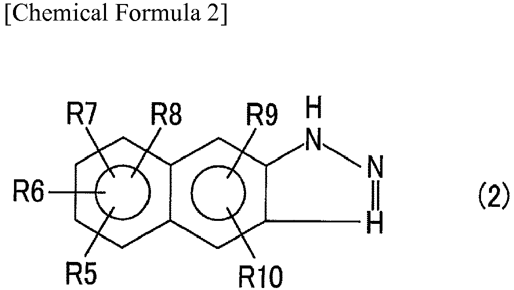

Each of R5 to R10 in general formula (2) independently represents a hydrogen atom, an alkyl group or alkoxy group having a carbon number of 1 to 16, and preferably a carbon number of 5 to 16, F, Br, Cl, I, a cyano group, an amino group, or an OH group.

Imidazole-based derivatives that can be used favorably in the manufacturing method of the present embodiment are represented by general formula (3).

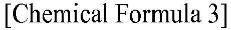

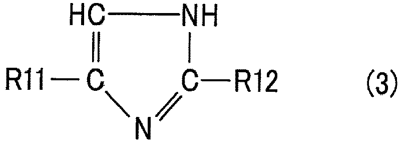

Each of R11 and R12 in general formula (3) independently represents a hydrogen atom, an alkyl group or alkoxy group having a carbon number of 1 to 16, F, Br, Cl, I, a cyano group, an amino group, or an OH group.

Benzimidazole-based derivatives that can be used favorably in the manufacturing method of the present embodiment are represented by general formula (4).

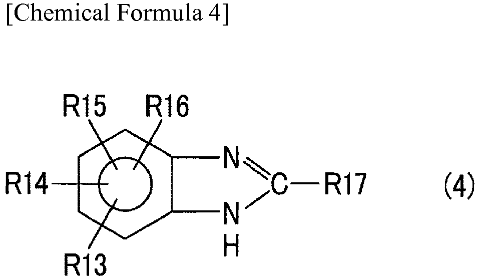

Each of R13 to R17 in general formula (4) independently represents a hydrogen atom, an alkyl group or alkoxy group having a carbon number of 1 to 16, F, Br, Cl, I, a cyano group, an amino group, or an OH group.

The imidazole-based derivatives and benzimidazole-based derivatives represented by general formula (3) and general formula (4) respectively also tend to exhibit greater tackiness as the carbon number of R11 to R17 increases. Accordingly, the carbon number of each of R11 to R17 is preferably from 5 to 16.

Mercaptobenzothiazole-based derivatives that can be used favorably in the manufacturing method of the present embodiment are represented by general formula (5).

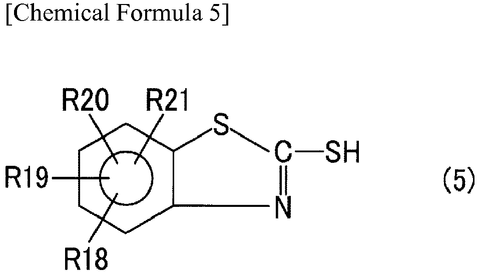

Each of R18 to R21 in general formula (5) independently represents a hydrogen atom, an alkyl group or alkoxy group having a carbon number of 1 to 16, and preferably a carbon number of 5 to 16, F, Br, Cl, I, a cyano group, an amino group, or an OH group.

Benzothiazole thio-fatty acid-based derivatives that can be used favorably in the manufacturing method of the present embodiment are represented by general formula (6).

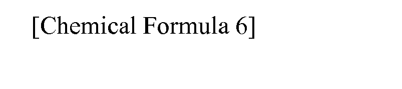

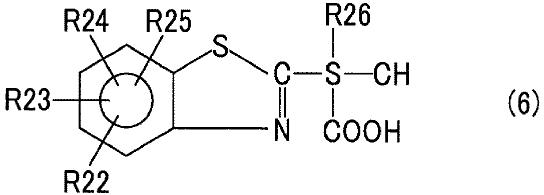

Each of R22 to R26 in general formula (6) independently represents a hydrogen atom, an alkyl group or alkoxy group having a carbon number of 1 to 16, and preferably a carbon number of 1 or 2, F, Br, Cl, I, a cyano group, an amino group, or an OH group.

The tackifier compound described above is preferably reacted in the form of a slightly acidic solution with a pH of about 3 to 4 prepared by dissolving the tackifier compound in water or acidic water. Examples of substances that may be used in adjusting the pH of this type of tackifier compound solution in those cases when the conductive material is a metal include inorganic acids such as hydrochloric acid, sulfuric acid, nitric acid and phosphoric acid, or organic acids such as formic acid, acetic acid, propionic acid, malic acid, oxalic acid, malonic acid, succinic acid and tartaric acid.

The concentration of the tackifier compound upon dissolution is not strictly limited, and may be set appropriately in accordance with the solubility of the compound and the usage situation, but is preferably within a range from 0.05% by mass to 20% by mass. Setting the concentration within this range facilitates handling of the tackifier compound. If the concentration is lower than this range, then formation of the tacky portion 28 may be unsatisfactory, which is undesirable.

Next, either the printed wiring board 23 illustrated in FIG. 2(b) is dipped in the tackifier compound solution, or the tackifier compound solution is injected onto the surface 25a of the circuit pattern 25 in the bonding location 26. As a result, tackiness is imparted to the surface 25a of the circuit pattern 25 in the bonding location 26, as illustrated in FIG. 2(c), thus forming a tacky portion 28.

The preferred temperature for reacting the tackifier compound varies depending on the concentration of the tackifier compound and the type of conductive material and the like, and there are no particular limitations. However, the temperature during the reaction of the tackifier compound is preferably slightly higher than room temperature, and a temperature within a range from 30°C to 60°C is preferred. This ensures that the rate of formation and the amount of the tacky portion 28 are appropriate.

Further, although there are no particular limitations on the dipping time during the reaction of the tackifier compound, from the viewpoint of operational efficiency, the other reaction conditions are preferably adjusted so that the dipping time is within a range from about 5 seconds to 5 minutes.

From the viewpoint of enhancing the production efficiency of the tacky portion 28, including the rate of formation and the amount of the tacky portion 28, the solution of the tackifier compound preferably also includes a concentration of about 100 to 1,000 ppm of copper ions.

Subsequently, the tacky portion 28 is washed with water and dried. In the manufacturing method of the present embodiment, the resist 27 is patterned finely in the resist formation step so as to conform to a fine pitch, and therefore as illustrated in FIG. 2(c), a printed wiring board 29 is obtained in which the tacky portion 28 has been formed on the surface 25a of the circuit pattern 25 in the fine pitch bonding location 26.

### [Solder Adhesion Step]

Next, a solder powder 30 is adhered to the tacky portion 28 by a method such as sprinkling the solder powder onto the printed wiring board 29. Subsequently, the excess solder powder is removed to obtain the printed wiring board 31 illustrated in FIG. 2(d).

Examples of the solder powder 30 used in the manufacturing method of the present embodiment include solders formed from solder alloys such as Sn-Pb-based alloys, Sn-Ag-based alloys, Sn-Pb-Ag-based alloys, Sn-Pb-Bi-based alloys, Sn-Pb-Bi-Ag-based alloys and Sn-Pb-Cd-based alloys. Further, in terms of the recent development of excluding Pb from industrial waste, the use of powders of Pb-free solder alloys for the solder powder 30, such as Sn-In-based alloys, Sn-Bi-based alloys, In-Ag-based alloys, In-Bi-based alloys, Sn-Zn-based alloys, Sn-Ag-based alloys, Sn-Cu-based alloys, Sn-Sb-based alloys, Sn-Au-based alloys, Sn-Bi-Ag-Cu-based alloys, Sn-Ge-based alloys, Sn-Bi-Cu-based alloys, Sn-Cu-Sb-Ag-based alloys, Sn-Ag-Zn-based alloys, Sn-Cu-Ag-based alloys, Sn-Bi-Sb-based alloys, Sn-Bi-Sb-Zn-based alloys, Sn-Bi-Cu-Zn-based alloys, Sn-Ag-Sb-based alloys, Sn-Ag-Sb-Zn-based alloys, Sn-Ag-Cu-Zn-based alloys and Sn-Zn-Bi-based alloys, is preferable.

Specific examples of the metal composition of the solder powder 30 include a eutectic solder composed of 63% by mass of Sn and 37% by mass of Pb (hereinafter abbreviated as 63Sn/37Pb) as the main option, but also include 96.5Sn/3.5Ag, 62Sn/36Pb/2Ag, 62.6Sn/37Pb/0.4Ag, 60Sn/40Pb, 50Sn/50Pb, 30Sn/70Pb, 25Sn/75Pb, 10Sn/88Pb/2Ag, 46Sn/8Bi/46Pb, 57Sn/3Bi/40Pb, 42Sn/42Pb/14Bi/2Ag, 45Sn/4OPb/15Bi, 50Sn/32Pb/18Cd, 48Sn/52In, 43Sn/57Bi, 97In/3Ag, 58Sn/42In, 95In/5Bi, 60Sn/40Bi, 91Sn/9Zn, 96.5Sn/3.5Ag, 99.3Sn/0.7Cu, 95Sn/5Sb, 20Sn/80Au, 90Sn/10Ag, 90Sn/7.5Bi/2Ag/0.5Cu, 97Sn/3Cu, 99Sn/1Ge, 92Sn/7.5Bi/0.5Cu, 97Sn/2Cu/0.8Sb/0.2Ag, 95.5Sn/3.5Ag/1Zn, 95.5Sn/4Cu/0.5Ag, 52Sn/45Bi/3Sb, 51Sn/45Bi/3Sb/1Zn, 85Sn/10Bi/5Sb, 84Sn/10Bi/5Sb/1Zn, 88.2Sn/10Bi/0.8Cu/1Zn, 89Sn/4Ag/7Sb, 88Sn/4Ag/7Sb/1Zn, 98Sn/1Ag/1Sb, 97Sn/1Ag/1Sb/1Zn, 91.2Sn/2Ag/0.8Cu/6Zn, 89Sn/8Zn/3Bi, 86Sn/8Zn/6Bi and 89.1Sn/2Ag/0.9Cu/BZn. Furthermore, a mixture of two or more types of solder powders having different metal compositions may also be used.

The average particle size of the solder powder 30 in the manufacturing method of the present embodiment may be set appropriately in accordance with the specifications prescribed in the Japanese Industrial Standards (JIS). In the JIS, particle sizes for solder powders are generally specified in terms of a particle size range of 63 to 22 µm, 45 to 22 µm, or 38 to 22 µm or the like, which is measured by sieving.

### [Second Heating Step]

In the manufacturing method of the present embodiment, a second heating step is preferably provided immediately after the solder adhesion step illustrated in FIG. 2(d). The second heating step is a step for enhancing the holding power of the solder powder 30 to the tacky portion 28. Accordingly, by performing the second heating step, the solder powder 30 is less likely to detach from the tacky portion 28 during the steps following the second heating step.

The temperature of the second heating step is preferably from 100°C to 180°C. Particularly in those cases where the solder powder is an Sn-Pb-based solder powder or an Sn-Ag-based solder powder, the heating temperature is preferably within the above range. By ensuring the heating temperature satisfies the above temperature range, the adhesive strength of the tacky portion 28 can be further enhanced.

Furthermore, in those cases where, as described above, copper is used as the conductive material and a benzotriazole-based derivative, naphthotriazole-based derivative, imidazole-based derivative, benzimidazole-based derivative, mercaptobenzothiazole-based derivative, or benzothiazole thio-fatty acid-based derivative or the like is used as the tackifier compound, the heating temperature of the printed wiring board 31 in this step is preferably within the range from 100°C to 180°C, and the heating time is preferably set within a range from 30 to 120 seconds. By employing these conditions, the adhesive strength of the tacky portion 28 can be further enhanced.

### [Resist Removal Step]

Next, the resist 27 is stripped from the printed wiring board 31. There are no particular limitations on the type of stripping solution used, provided it does not dissolve or degrade the solder powder 30 or the tacky portion 28. Further, as described above, when a benzotriazole-based derivative, naphthotriazole-based derivative, imidazole-based derivative, benzimidazole-based derivative, mercaptobenzothiazole-based derivative, or benzothiazole thio-fatty acid-based derivative or the like is used as the tackifier compound, a stripping solution that does not degrade these tackifier compounds is used. Examples of such stripping solutions include alkaline stripping solutions of tetramethylammonium hydroxide (TMAH), tetrabutylammonium hydroxide (TBAH) or an ammonium salt or the like.

Further, when the resist is an alkali development type resist, the resist is preferably removed using an alkaline solution in the resist removal step. As mentioned above, the resist is preferably an alkali development type resist. Accordingly, by using an alkaline solution, removal of the resist can be performed easily. Further, if an alkaline solution is used, then by using a tacky portion having alkali resistance, detachment of the solder powder can be suppressed.

As illustrated in FIG. 2(e), by performing the resist removal step, a printed wiring board 32 is obtained from which the resist 27 has been stripped. In the resist formation step and the tacky portion formation step, because a tacky portion 28 having a fine pitch pattern is formed, the solder powder 30 is formed on the printed wiring board 32 with a fine pitch.

In the manufacturing method of the present embodiment, the resist removal step may be performed after the tacky portion formation step, and the solder adhesion step then performed after the resist removal step. This type of manufacturing method also yields the printed wiring board 32.

Furthermore, in the manufacturing method of the present embodiment, a step of applying a flux to the solder powder 30 may be provided between the resist removal step and the first heating step described below. Including this step enables the melting properties of the solder powder 30 in the first heating step to be improved. A rosin or the like can be used as the flux applied to the solder powder 30.

### [First Heating Step]

Next, the solder powder 30 on the printed wiring board 32 is melted, thus obtaining a solder circuit board 34 in which a solder layer 33 has been formed on the surface 25a of the circuit pattern 25 in the bonding location 26, as illustrated in FIG. 2(f). The solder layer 33 is used to subsequently form a solder circuit.

The heating temperature and the heating time employed when melting the solder powder 30 may be set as appropriate with due consideration of the alloy composition and the particle size of the solder powder 30. For example, in the case where a powder composed of an Sn-Zn-based solder alloy such as 91Sn/9Zn, 89Sn/8Zn/3Bi or 86Sn/8Zn/6Bi is used as the solder powder 30, the heating temperature is typically set to 210 to 230°C, and preferably 210 to 220°C, and the heating time is typically set to 30 to 60 seconds, and preferably 30 to 40 seconds. Further, in the case where a powder composed of an Sn-Pb-based alloy is used as the solder powder 30, the heating temperature is typically set to 200 to 350°C, and preferably 200 to 250°C, and the heating time is typically set to 30 to 60 seconds, and preferably 30 to 40 seconds. Moreover, in the case where a powder composed of an Sn-Ag-based alloy is used as the solder powder 30, the heating temperature is typically set to 250 to 350°C, and preferably 220 to 270°C, and the heating time is typically set to 30 to 60 seconds, and preferably 30 to 40 seconds.

By employing these types of conditions, the solder powder 30 can be melted favorably. Furthermore, in this step, the surface tension of the solder powder 30 and the adhesive strength of the tacky portion 28 mean that the solder undergoes almost no broadening from the tacky portion 28, enabling the formation of a solder layer 33 of satisfactory thickness.

In those cases where a solder powder 30 of another alloy is used, the heating temperature is typically set to a temperature that is +20 to +50°C higher than the melting point of the solder alloy, and preferably a temperature that is +20 to +30°C higher than the melting point of the solder alloy. The heating temperature is typically within a range from 200°C to 350°C, and the heating time is typically set within a similar range to those mentioned above.

### [Electronic Component Bonding Step]

Next, in the case where a fine pitch bare chip is to be mounted as an electronic component 35, a flip chip bonder or the like is used to position the solder layer 33 and bumps 36 formed on the electrodes of the bare chip as illustrated in FIG. 2(g), and pressure is then applied while the structure is heated. By performing this step, a mounted board 38 is obtained in which the solder has melted and connected to a solder circuit 37, as illustrated in FIG. 2(h).

Using a resistor, capacitor, transformer, inductance, filter, oscillator or transducer or the like as the electronic component 35 illustrated in FIG. 2(g) and FIG. 2(h), surface-mount technology (SMT) can be used as the method for bonding the electronic component 35 to the solder circuit board 34. In SMT, a solder paste is first applied to the bonding location 26 on the surface 25a of the circuit pattern 25 using a screen printing method. Subsequently, the electronic component 35 such as a chip component or QFP is mounted on the solder paste, which is not shown in the drawings, and a reflow heat source is then used to perform collective solder bonding. In this type of reflow process, a hot-air oven, infrared oven, steam condensation soldering apparatus, or light beam soldering apparatus or the like can be used as the reflow heat source.

The conditions for the reflow process described above vary depending on the metal composition of the solder powder 30 and the solder paste, and are therefore set appropriately with due consideration of these metal compositions. For example, in the case where an Sn-Zn-based solder alloy such as 91Sn/9Zn, 89Sn/8Zn/3Bi or 86Sn/8Zn/6Bi is used as the solder powder 30 and the solder paste, a two-stage process composed of a preheating step and a reflow step is preferably performed. The conditions for each of the steps in this type of two-stage process include a preheating temperature of 130 to 180°C, and preferably 130 to 150°C, and a preheating time of 60 to 120 seconds, and preferably 60 to 90 seconds. Further, the reflow temperature is typically 210 to 230°C, and preferably 210 to 220°C, and the reflow time is typically 30 to 60 seconds, and preferably 30 to 40 seconds. In those cases where the solder powder 30 and the solder paste are formed from another alloy, the reflow temperature is typically set to a temperature that is +20 to +50°C higher than the melting point of the solder alloy, and preferably a temperature that is +20 to +30°C higher than the melting point of the solder alloy, whereas the preheating temperature, the preheating time and the reflow time may be set within the respective ranges described above.

The reflow process described above may be performed in a nitrogen atmosphere or in air. When the reflow is performed in nitrogen, by ensuring that the oxygen concentration is not more than 5% by volume, and preferably 0.5% by volume or less, the wettability of the solder layer 33 with the solder paste can be improved and the formation of solder balls can be suppressed compared with the case where the reflow is performed in air, thus enabling a more stable treatment to be performed.

Following the reflow process, the solder circuit board 34 is cooled to complete the surface mounting. This type of electronic component bonding by SMT may also be performed on both surfaces of the printed wiring board 24.

As described above, in the method for manufacturing a solder circuit board according to the present embodiment, because the resist removal step is performed between the tacky portion formation step and the first heating step, the resist 27 can be removed before the solder powder 30 applied to the bonding location 26 on the surface 25a of the circuit pattern 25 is melted. As a result, in the resist formation step, a resist 27 that is applicable to photolithography techniques that yield very fine patterns can be used, even if the resist lacks heat resistance at the melting temperature of the solder powder. Accordingly, the resist 27 can be patterned with a very fine pattern in the order of 20 µm. As a result, the portion of the surface 25a of the circuit pattern 25 on the printed wiring board 23 that is not coated with the resist, namely the bonding location 26 for the electronic component, is formed with a fine pitch, and the tacky portion 28 and the solder particles 30 that are subsequently formed sequentially at the bonding location 26 are also formed with a fine pitch. At the same time, the amount of solder used can be suppressed to a minimum. In this manner, once the first heating step has been completed, a solder circuit board 34 is obtained on which a solder layer 33 with a very fine pattern corresponding with the fine pitch has been formed.

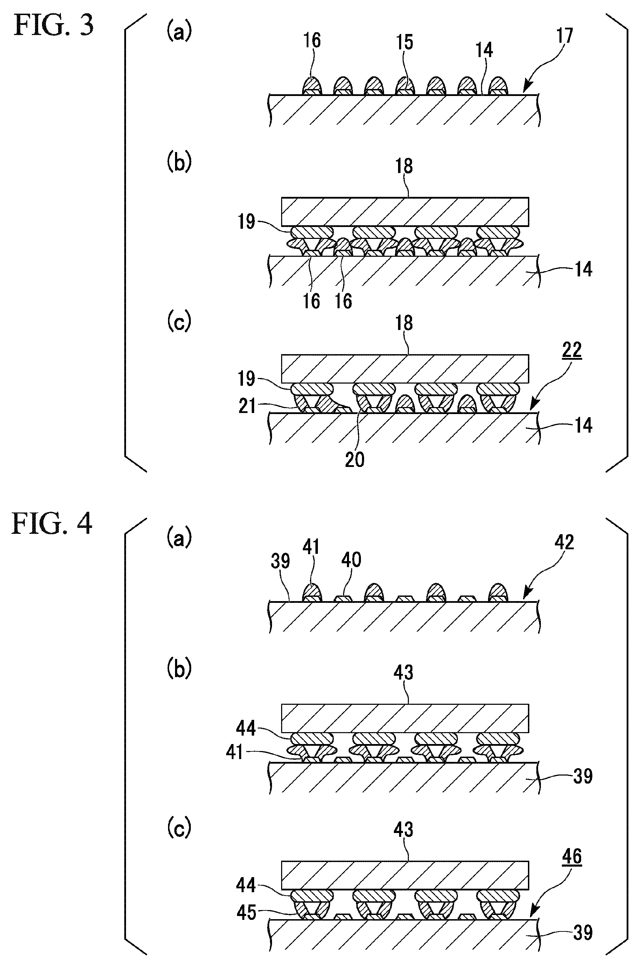

Next is a description of the bonding step for a fine pitch bare chip having an electrode portion between electrodes. In a bare chip on which two lines of electrodes are formed, usually a solder circuit board 17 illustrated in FIG. 3(a) is formed, and then as illustrated in FIG. 3(b), stud bumps 19 formed on the electrode portions of an electronic component 18 are positioned on top of the solder bumps 15 that have been formed so as to cover the circuit pattern, and a flip chip bonder is then used to heat the structure while pressure is applied. Although dependent on the heating and pressure conditions, and any positional misalignment, because the spacing of the electrodes 16 is very fine, the solder may sometimes contact adjacent electrodes 16, as illustrated in FIG. 3(b). In this case, when the solder is completely melted, a mounted board 22 is obtained with the type of solder circuit 20 illustrated in FIG. 3(c), in which partial bridging such as that shown for the electrode 21 may occur.

In contrast, in the manufacturing method of the present embodiment, by forming the resist layer (not shown in the drawings) on every second electrode surface of a circuit pattern 40 on a substrate 39, a solder circuit board 42 illustrated in FIG. 4(a) can be fabricated, in which the solder layer has been formed on every second electrode. If the electrodes 41 of this solder circuit board 42 with the solder layer formed thereon and electrodes 44 of an electronic component 43 are heated while pressure is applied using a flip chip bonder, such as the situation illustrated in FIG. 4(b), then as illustrated in FIG. 4(c), the solder melts and connects to the solder circuit 45, yielding a mounted board 46 with no bridging.

Although preferred embodiments of the present invention have been described above, the present invention is in no way limited by these specific embodiments, and various modifications and alterations are possible within the scope of the invention disclosed in the claims.

### EXAMPLES

The present invention is described below using a series of examples, but the present invention is in no way limited by these examples.

### (Example 1)

A printed wiring board was fabricated using copper as the conductive material (hereafter simply referred to as "the printed wiring board"). The line width of the conductive material circuit pattern of this printed wiring board was 25 µm, and the narrowest gap within the circuit pattern was 25 µm. A substrate was prepared by affixing a photoresist (model number: H-7034, manufactured by Hitachi Chemical Co., Ltd.) to this printed wiring board. Using a photomask, the printed wiring board was exposed to ultraviolet radiation, and an alkali developing solution, for example a 1% aqueous solution of sodium carbonate, was then used to pattern the printed wiring board. The region on the surface of the conductive circuit electrodes not coated with the resist was composed of an area of 25 × 80 µm on every second electrode.

A 2% by mass aqueous solution of an imidazole-based compound of general formula (3), in which R12 represents a C₁₁H₂₃ alkyl group and R11 represents a hydrogen atom, which had been adjusted to a pH of about 4 using acetic acid, was used as the tackifier compound solution. This aqueous solution of the imidazole-based compound was heated to 40°C, and the printed wiring board, which had been pretreated with an aqueous solution of hydrochloric acid, was then dipped in the imidazole-based compound solution for 3 minutes, thereby forming tacky portions in the open areas of the resist.

Subsequently, the printed wiring board was washed with water and then dried. A solder powder having an average particle size of about 10 µm and an alloy composition of 63Sn/37Pb was sprinkled onto the printed wiring board, and gentle brushing was then used to adhere the solder powder selectively to the tacky portions. Subsequently, the printed wiring board was heated at 120°C for 10 minutes, and the photoresist formed on the surface of the printed wiring board was then stripped away using a 3% aqueous solution of sodium hydroxide as an alkaline stripping solution. Following application of a polymerized rosin to the portions on the printed wiring board where the solder powder had been positioned, the printed wiring board was placed in an oven at 240°C to melt the solder powder. As a result, a solder circuit board was obtained in which a eutectic solder layer of about 10 µm had been formed on those portions of the copper circuit pattern to which the solder powder had been adhered.

Next, the printed wiring board with the solder bumps formed thereon was installed in a flip chip bonder and heated to 160°C. A bare chip was then mounted to the printed wiring board while undergoing heating at 230°C, with the mounting performed so that the electrodes of the chip, which had stud bumps (diameter: 50 µm × height: 80 µm) formed thereon (electrode pitch: 100 µm) were aligned with the electrodes of the printed wiring board.

### (Example 2)

With the exception of not performing the heating of the printed wiring board after the solder powder adhesion (namely, the second heating step), the same steps and conditions as those described for Example 1 were used to mount a bare chip to a printed wiring board.

### (Comparative Example)

Using a substrate to which a photoresist had not been affixed as a printed wiring board, tackiness was imparted to the circuit pattern without prior coating with a resist, and a solder powder was then adhered to the tacky portions. Thereafter, the same steps and conditions as those described for Example 1 were used to mount a bare chip to the printed wiring board.

### (Evaluations of Example 1, Example 2 and Comparative Example)

As shown in Table 1, in each of the solder circuit boards on which a bare chip had been mounted using the steps described above, very fine bumps having substantially the same bump height were able to be formed in Example 1, Example 2 and the Comparative Example. In Example 1, performing the second heating step enabled detachment of the solder powder to be suppressed during the photoresist stripping step, and therefore the bump height was able to be maintained. Further, in the flip chip mounting, favorable mounting boards were obtained in Example 1 and Example 2 where a photoresist had been formed on the printed wiring board, whereas bridging was detected on the mounting board of the Comparative Example in which no photoresist had been formed on the printed wiring board.

**[Table 1]**

| | Photoresist formation | Second heating step | Solder bump height | Solder bump external shape | Flip chip mounting |
|---|---|---|---|---|---|
| Example 1 | yes | 120°C × 20 min | 10.0 µm | 25 × 80 µm | favorable |
| Example 2 | yes | none | 9.2 µm | 25 × 80 µm | favorable |
| Comparative Example | no | none | 10.2 µm | 25 × 200 µm | bridging |

In Example 1 and Example 2 described above, the photoresist was removed after adhering the solder powder to the tacky portion, and the solder powder was subsequently melted, and therefore the resist did not exist on the substrate at the time of solder melting, meaning there was no necessity to use a heat-resistant resist. Accordingly, as is evident from the evaluation results shown in Table 1, by using the present invention, a favorable fine pitch solder circuit could be formed, and the stud bumps of the electronic component could be lowered.

### DESCRIPTION OF THE REFERENCE SIGNS

2, 25, 40: Circuit pattern (conductive circuit electrodes)
3, 26: Bonding location (portion not coated with resist)
4, 27: Resist
5, 28: Tacky portion
6,30: Solder powder
8, 12, 23, 29, 31, 32, 34, 38: Printed wiring board
25a: Surface
17, 34: Solder circuit board

## Claims

1. A method for manufacturing a solder circuit board, the method comprising performing, in sequence:
a resist formation step of partially coating a conductive circuit electrode surface on a printed wiring board with a resist,
a tacky portion formation step of forming a tacky portion by imparting tackiness to a portion of the conductive circuit electrode surface not coated with the resist,
a solder adhesion step of adhering a solder powder to the tacky portion,
a resist removal step of removing the resist, and
a first heating step of heating the printed wiring board and melting the solder powder.

2. A method for manufacturing a solder circuit board, the method comprising performing, in sequence:
a resist formation step of partially coating a conductive circuit electrode surface on a printed wiring board with a resist,
a tacky portion formation step of forming a tacky portion by imparting tackiness to a portion of the conductive circuit electrode surface not coated with the resist,
a resist removal step of removing the resist,
a solder adhesion step of adhering a solder powder to the tacky portion, and
a first heating step of heating the printed wiring board and melting the solder powder.

3. The method for manufacturing a solder circuit board according to Claim 1 or 2, wherein a second heating step is provided immediately after the solder adhesion step.

4. The method for manufacturing a solder circuit board according to Claim 1 or 2, wherein a step of applying a flux to the solder powder is provided between the resist removal step and the first heating step.

5. The method for manufacturing a solder circuit board according to Claim 1 or 2, wherein
the resist is an alkali development type resist, and
in the resist removal step, an alkaline solution is used to remove the resist.

6. The method for manufacturing a solder circuit board according to Claim 3, wherein
the solder powder is an Sn-Pb-based solder powder,
a heating temperature in the first heating step is within a range from 200°C to 350°C,and
a heating temperature in the second heating step is within a range from 100°C to 180°C.

7. The method for manufacturing a solder circuit board according to Claim 3, wherein
the solder powder is an Sn-Ag-based solder powder,
a heating temperature in the first heating step is within a range from 250°C to 350°C, and
a heating temperature in the second heating step is within a range from 100°C to 180°C.

8. The method for manufacturing a solder circuit board according to Claim 1 or 2, wherein
the conductive circuit electrode is formed from a copper alloy, and
in the tacky portion formation step, a reaction between the copper alloy and a benzotriazole-based derivative, naphthotriazole-based derivative, imidazole-based derivative, benzimidazole-based derivative, mercaptobenzothiazole-based derivative or benzothiazole thio-fatty acid-based derivative is used to impart tackiness to the portion not coated with the resist.

9. A solder circuit board fabricated using the method for manufacturing a solder circuit board according to Claim 1 or 2.

10. A method for mounting an electronic component, the method comprising:
an electronic component mounting step of mounting an electronic component on the solder circuit board according to Claim 9, and
an electronic component bonding step of subjecting the solder powder to reflow to bond an electrode portion of the electronic component to the solder circuit board.
